(19) Europäisches Patentamt
European Patent Office
Office européen des brevets

(11) EP 0 302 019 B1

(12) EUROPÄISCHE PATENTSCHRIFT

(45) Veröffentlichungstag und Bekanntmachung des Hinweises auf die Patenterteilung:
**13.03.1996 Patentblatt 1996/11**

(51) Int Cl.[6]: **G03F 7/038**

(21) Anmeldenummer: **88810506.1**

(22) Anmeldetag: **22.07.1988**

# (54) Negativ-Photoresist auf Basis von Polyphenolen und ausgewählten Epoxid-oder Vinyletherverbindungen

Negative photoresists on the basis of polyphenols and a choice of epoxide or vinyl ether compounds

Photoréserves négatives à base de polyphénols et un choix d'époxydes ou de vinyléthers

(84) Benannte Vertragsstaaten:
**CH DE FR GB IT LI NL SE**

(30) Priorität: **28.07.1987 CH 2871/87**
**16.02.1988 CH 546/88**

(43) Veröffentlichungstag der Anmeldung:
**01.02.1989 Patentblatt 1989/05**

(73) Patentinhaber: **CIBA-GEIGY AG**
**CH-4002 Basel (CH)**

(72) Erfinder:
- **Meier, Kurt, Dr.**
  **CH-4102 Binningen (CH)**
- **Roth, Martin, Dr.**
  **CH-1735 Giffers (CH)**
- **Schulthess, Adrian, Dr.**
  **CH-1734 Tentlingen (CH)**
- **Wolleb, Heinz, Dr.**
  **CH-1731 Ependes (CH)**

(56) Entgegenhaltungen:
**EP-A- 0 255 989** **US-A- 4 273 889**
**US-A- 4 442 197** **US-A- 4 632 971**

- **PATENT ABSTRACTS OF JAPAN vol. 9, no. 205 (C-299)(1928) 22 August 1985, & JP-A-60 71 657**

Bemerkungen:
Die Akte enthält technische Angaben, die nach dem Eingang der Anmeldung eingereicht wurden und die nicht in dieser Patentschrift enthalten sind.

EP 0 302 019 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die vorliegende Erfindung betrifft eine Zusammensetzung enthaltend im wesentlichen Polyphenole und ausgewählte Phenole mit Epoxypropylseitengruppen und/oder Vinyletherverbindungen und Photoinitiatoren, ein Verfahren zur Herstellung von Reliefstrukturen und Schutzschichten und die Verwendung besagter Zusammensetzungen als alkalisch-wässrig-entwickelbarer Negativ-Resist.

Negativresists auf Epoxidbasis sind bekannt. In der EP-A 153,904 wird ein Verfahren zur Herstellung von Schutzschichten und von Reliefstrukturen beschrieben, wobei ein solcher strahlungsempfindlicher Film verwendet wird. Das System wird mit organischen Lösungsmitteln entwickelt.

Aus der JP-A-60-71,657 sind Kombinationen von vinylethermodifizierten Novolaken und Haloniumsalzen bekannt, die sich als Photoresists einsetzen lassen. Diese Kombinationen lassen sich, bedingt durch den geringen Gehalt an phenolischen OH-Gruppen nicht alkalisch-wässrig entwickeln.

Aus der GB-A 2,009,435 sind rein wässrig entwickelbare Negativ-Resists bekannt, worin ein wasserlösliches oder quellbares Bindemittel, u.a. Polyvinylalkohol, und ein Acrylmonomeres als polymerisierbare Komponente verwendet werden. Systeme auf Acrylatbasis sind den Epoxidsystemen im allgemeinen hinsichtlich der mechanischen und elektrischen Eigenschaften, der Temperaturstabilität und der Adhäsion auf dem Substrat unterlegen. Ausserdem sind rein wässrig entwickelbare Systeme im Gegensatz zu alkalisch-wässrig oder sauer-wässrig entwickelbaren Systemen relativ feuchtigkeitsempfindlich und ihre Lagerstabilität ist begrenzt.

In der EP-A 124,292 wird eine wässrige Dispersion eines Epoxidharzes und eines Onium-Photoinitiators beschrieben. Die Zusammensetzung wird zur Herstellung von Schutzschichten und von Reliefabbildungen eingesetzt und ist wässrig entwickelbar. Den Dispersionen werden bevorzugt Netzmittel oder Schutzkolloide, beispielsweise Polyvinylalkohol, zugesetzt. Es ist allerdings nicht jedes Epoxidharz geeignet; so muss in einigen Fällen ein reaktiver Verdünner zugesetzt werden, um die Dispergierbarkeit zu gewährleisten.

Gemäss der EP-A-0 255 989 werden Zusammensetzungen vorgeschlagen, die im wesentlichen aus a) mindestens einem festen filmbildenden Polyphenol, b) mindestens einer Verbindung, die wenigstens zwei Epoxygruppen oder wenigstens zwei Vinylethergruppen oder wenigstens eine Epoxid- und eine Vinylethergruppe im Molekül aufweist, ferner c) mindestens aus einem kationischen Photoinitiator für die Komponente b), und gegebenenfalls d) üblichen Zusätzen bestehen. Wässrig-alkalische Komponenten b) werden dort nicht beschrieben.

US-A-4,273,889 beschreibt härtbare Zusammensetzungen bestehend aus einem linearen Homopolymer von Isopropenylphenol und einem Epoxidharz. Diese Zusammensetzungen können thermisch oder radikalisch vernetzt werden, wobei hierfür bestimmte Katalysatoren eingesetzt werden können.

Aus US-A-4,442,197 sind strahlungshärtbare Zusammensetzungen auf Basis eines kationisch polymerisierbaren Materials und eines kationischen Photoinitiators bekannt. Die dort beschriebenen Systeme sind wässrigalkalisch nicht entwickelbar.

Schliesslich werden gemäss Patents Abstracts of Japan, Vol. 9, No. 205, (C-299)(1528) 22.8.85 Zusammensetzungen auf Basis eines Vinylethermodifizierten Polyphenols und eines kationisch wirksamen Photoinitiators vorgeschlagen. Die dort beschriebenen Polyphenole weisen einen derart hohen Umsetzungsgrad der Hydroxylgruppen zu Vinyletherfunktion, dass sie nicht mehr alkalisch-wässrig entwickelbar sind.

Es wurde jetzt gefunden, dass man alkalisch-wässrig entwickelbare Negativ-Resists auf Epoxid- oder Vinyletherbasis herstellen kann, indem man ausgewählte Epoxy-Phenole und/oder Vinylether mit Bindemitteln auf der Basis von Polyphenolen kombiniert. Ferner wurde gefunden, dass sich solche Gemische problemlos und ökonomisch entwickeln lassen, da sich die Komponenten in den nicht vernetzten Bereichen im Entwickler lösen lassen. Ein weiterer Vorteil der erfindungsgemässen Resists ist die hohe Differenzierung zwischen den bestrahlten und nichtbestrahlten Bereichen. So lässt sich der Resist ohne Rückstände in sehr kurzer Zeit aus den nicht belichteten Flächenanteilen herausentwickeln und stört somit nicht die folgenden Verarbeitungsschritte.

Die vorliegende Erfindung betrifft eine kationisch photopolymerisierbare Zusammensetzung bestehend im wesentlichen aus

a1) mindestens einem festen, filmbildenden Polyphenol,
b1) mindestens einem Phenol mit Epoxypropylseitengruppen und/oder einer polyfunktionellen Vinyletherverbindung, welche ein solches Ausmass an Hydroxylgruppen aufweisen, dass sie sich in ungehärtetem Zustand unter Salzbildung in einer alkalisch-wässrigen Lösung lösen lassen,
c1) mindestens einem Oniumsalz mit einem Anion mit schwacher Nucleophilie oder einem Metallocensalz als kationischen Photoinitiator für die Komponente b1) und
d1) gegebenenfalls üblichen Zusätzen.

Das Bindemittel a1) ist ein festes, filmbildendes Polyphenol, d.h. ein Polymer, das einen bestimmten Gehalt an phenolischen Hydroxylgruppen aufweist. Dieser sollte zumindest so hoch sein, dass die Entwicklung oder zumindest

die Quellung in einer wässrig alkalischen Entwicklerlösung gewährleistet ist.

Geeignete alkalisch-wässrig lösliche, filmbildende Bindemittel a1) lassen sich im allgemeinen in folgende Gruppen einteilen:

i) Novolake aus mindestens einem Phenol und mindestens einem Aldehyd,
ii) Homo- und Copolymere von Alkenylphenolen und insbesondere
iii) Homo- und Copolymere von N-Hydroxyphenylmaleinimiden.

Bevorzugt werden dabei die Gruppen ii) und iii).

Bevorzugte Novolake i) sind Verbindungen, die sich von einem $C_1$-$C_6$-Aldehyd, beispielsweise Formaldehyd und Acetaldehyd, und von einem zweikernigen, bevorzugt jedoch einkernigen, gegebenenfalls substituierten Phenol ableitet. Beispiele für bevorzugte Phenole sind Phenol selbst oder mit ein oder zwei $C_1$-$C_9$Alkylgruppen substituierte Phenole, wie beispielsweise o-, m- oder p-Kresol, Xylenol, p-tert.Butylphenol und o-, m- oder p-Nonylphenol, oder mit ein oder zwei Halogenatomen, bevorzugt Chlor oder Brom, substituierte Phenole, beispielsweise p-Chlorphenol, mit einem Phenylkern substituierte Phenole, wie z.B. p-Phenylphenol, oder auch Phenole mit mehr als einer phenolischen Gruppe, wie z.B. Resorcin, Bis-(4-hydroxyphenyl)-methan oder 2,2-Bis-(4-hydroxyphenyl)propan.

Bevorzugte Homo- oder Copolymere von Alkenylphenolen ii) sind insbesondere die Verbindungen der Formel I

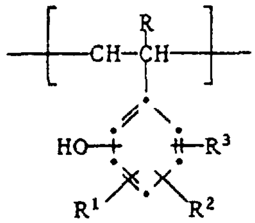

(I),

worin R Wasserstoff oder Methyl ist, $R^1$, $R^2$ und $R^3$ unabhängig voneinander Wasserstoff, $C_1$-$C_4$Alkyl, $C_1$-$C_4$Alkoxy, Halogen, insbesondere Chlor oder Brom, und Methylol bedeuten. Die phenolische Hydroxylgruppe ist in o-, m oder p-Position zur Alkenylgruppe angeordnet, bevorzugt jedoch in p-Position.

Als Comonomere kommen beispielsweise carboxylgruppenfreie Vinylmonomere in Betracht. Beispiele für solche Monomere sind Styrol, Acryl- und Methacrylsäureester, insbesondere (Meth)acrylsäuremethylester oder (Meth)acrylsäure-2-hydroxyethylester, Acrylamid, Vinylacetat und N-substituierte Maleinimide.

Der Comonomerenanteil der Bindemittel des Typs ii) beträgt bevorzugt 0-50 Mol%, bezogen auf das Gesamtpolymere.

Polymere des Typs ii) sind bekannt und beispielsweise in der DE-OS 2,322,230 und in der EP-A 153,682 beschrieben. Teilweise sind solche Polymere auch im Handel erhältlich.

Bevorzugte Bindemittel des Typs iii) sind Copolymere auf Basis von N-Hydroxyphenylmaleinimiden und Vinylmonomeren. Die Bindemittel des Typs iii) enthalten bevorzugt die Struktureinheit der Formel II

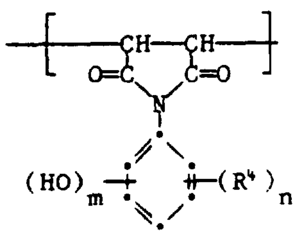

(II),

worin $R^4$ $C_1$-$C_4$Alkyl, $C_1$-$C_4$Alkoxy oder Halogen, insbesondere Chlor oder Brom ist, m 1 oder 2 darstellt, n 0, 1, 2, 3 oder 4 ist und die Summe von m und n höchstens 5 bedeutet, wobei die Reste $R^4$ eines Phenylkernes innerhalb der gegebenen Definitionen unterschiedlich sein können.

Eine weitere bevorzugte Gruppe von Bindemitteln des Typs iii) sind Copolymere auf der Basis von N-Hydroxyphenylmaleinimiden, insbesondere solche mit Strukturelementen der Formel II und carboxylgruppenfreien Vinylverbindungen.

Beispiele für geeignete Vinyl-Comonomere sind:

a) Styroltypen, wie beispielsweise Styrol, $\alpha$-Methylstyrol, p-Methylstyrol oder p-Hydroxyphenylstyrol;
b) Ester oder Amide $\alpha,\beta$-ungesättigter Säuren, wie beispielsweise Acrylsäuremethylester, Acrylsäureamid, die entsprechenden Methacrylverbindungen oder Maleinsäuremethylester;
c) Nitrile von $\alpha,\beta$-ungesättigten Säuren, wie beispielsweise Acrylnitril oder Methacrylnitril;

d) halogenhaltige Vinylverbindungen, wie beispielsweise Vinylchlorid, Vinylfluorid, Vinylidenchlorid oder Vinylidenfluorid;

e) Vinylester, wie beispielsweise Vinylacetat oder

f) Vinylether, wie beispielsweise Methylvinylether oder Butylvinylether.

Der Anteil der Vinylkomponente bei Bindemitteln des Typs iii) beträgt in der Regel 20 bis 70 Mol%, bevorzugt 40-60 Mol%, besonders bevorzugt etwa 50 Mol%, bezogen auf den Gesamtanteil an Monomereinheiten.

Homopolymere aus Struktureinheiten der Formel II und Copolymere mit Vinylverbindungen sind bekannt und werden beispielsweise in der BE-PS 613,801 sowie in Kobunshi Kagaku 26, 593-601 (1969) (Chem. Abstr. 72, 21964n) beschrieben. Ferner berichten Turner et al. in Photopolymer Conference, Ellenville Oct. 1985, S. 35-47 über den Einsatz von solchen Comonomeren mit Vinylverbindungen als Bindemittel in positiven Photolacken.

Eine weitere bevorzugte Gruppe von Bindemitteln des Typs iii) sind Copolymere auf der Basis von N-Hydroxyphenylmaleinimiden, insbesondere solche mit Strukturelementen der Formel II, Allylverbindungen und gegebenenfalls weiteren Vinylverbindungen.

Bei diesen Verbindungen handelt es sich insbesondere um Copolymere enthaltend 30-100 Mol%, bezogen auf das Gesamtpolymere, an Struktureinheiten der Formel II, wie oben definiert, und der Formel III, wobei der Anteil der Reste der Formel II, bezogen auf den gesamten Anteil von II und III, 5 bis 95 Mol% ausmacht

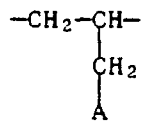 (III),

worin A ausgewählt wird aus der Gruppe der Reste bestehend aus Halogen, Cyano oder Struktureinheiten der Formeln IV bis IX

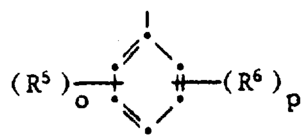 (IV), 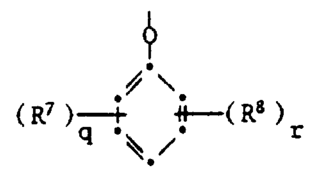 (V),

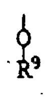 (VI), 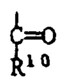 (VII), 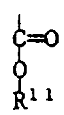 (VIII), 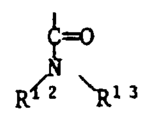 (IX),

worin $R^5$ und $R^7$ unabhängig voneinander Hydroxy- oder Glycidylgruppen der Formel Xa oder Xb darstellen

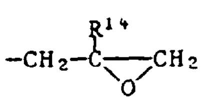 (Xa), 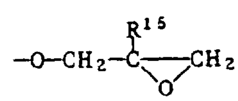 (Xb),

$R^6$ und $R^8$ unabhängig voneinander $C_1$-$C_4$Alkyl, $C_1$-$C_4$Alkoxy oder Halogen sind,
o und q unabhängig voneinander 0, 1, 2 oder 3 sind,
p und r unabhängig voneinander 0, 1, 2, 3, 4 oder 5 bedeuten, wobei die Summen o+p und q+r höchstens 5 betragen dürfen,
$R^9$ Wasserstoff, $C_1$-$C_{20}$Alkyl, ein Glycidylrest der Formel Xa oder ein Rest der Formel VII ist,
$R^{10}$ Wasserstoff, $C_1$-$C_{20}$Alkyl, Cycloalkyl mit 5 bis 7 Ring C-Atomen, Phenyl, Naphthyl oder Benzyl darstellt,
$R^{11}$ Wasserstoff, $C_1$-$C_{20}$Alkyl oder ein Glycidylrest der Formel Xa ist und die Gruppen $R^{12}$ und $R^{13}$ unabhängig voneinander Wasserstoff, $C_1$-$C_{20}$Alkyl, Cycloalkyl mit 5 bis 7 Ring C-Atomen, gegebenenfalls substituiertes Aryl oder Aralkyl oder ein Glycidylrest der Formel Xa sind oder zusammen mit dem gemeinsamen Stickstoffatom einen fünf-oder sechsgliedrigen heterocyclischen Ring bilden und $R^{14}$ und $R^{15}$ unabhängig voneinander Wasserstoff oder Methyl sind, wobei die Reste $R^5$ bis $R^{15}$ und A eines Polymermoleküls innerhalb der gegebenen Definitionen unterschiedlich sein können.

Besonders bevorzugte Bindemittel des Typs iii) sind Copolymere enthaltend 50-100 Mol%, bezogen auf das Gesamtpolymere, an Struktureinheiten der Formeln II und III.

Insbesondere bevorzugt werden Bindemittel des Typs iii) bestehend im wesentlichen aus Strukturelementen der Formeln II und III, worin der Anteil der Elemente II 10-80 Mol%, bezogen auf den Anteil von II und III, ausmacht.

Ganz besonders bevorzugte Bindemittel des Typs iii) sind Copolymere enthaltend Struktureinheiten der Formeln II

und III, wie oben definiert, worin A ausgewählt wird aus der Gruppe der Reste der Formeln IV, V, VI, VIII und IX, $R^5$ und $R^7$ Glycidylgruppen der Formeln Xa oder Xb darstellen, $R^9$, $R^{11}$ und mindestens einer der Reste $R^{12}$ oder $R^{13}$ eine Glycidylgruppe de Formel Xa ist und o und q unabhängig voneinander 1, 2 oder 3 sind.

Insbesondere bevorzugt werden Bindemittel des Typs iii), die Struktureinheiten der Formeln II und III, wie oben definiert, enthalten, worin A eine Gruppe der Formel VI ist und $R^9$ eine Gruppe der Formel Xa bedeutet, oder worin A eine Gruppe der Formeln IV oder V ist, $R^5$ und $R^7$ Glycidylgruppen der Formel Xb sind, o und q 1 oder 2 bedeuten und p und r 0 sind.

Weitere Bindemittel des Typs iii) sind Copolymere enthaltend mindestens 50 Mol%, bezogen auf das Gesamtpolymere, an Strukturelementen der Formel II und III und als restlichen Anteil Strukturelemente, die sich von carboxylgruppenfreien Vinylverbindungen ausgewählt aus der Gruppe bestehend aus Styroltypen, Estern oder Amiden $\alpha,\beta$-ungesättigter Säuren, Nitrilen von $\alpha,\beta$-ungesättigten Säuren, halogenhaltigen Vinylverbindungen, Vinylestern und Vinylethern ableiten.

Copolymere aus N-Hydroxyphenylmaleinimiden und Allylverbindungen wurden bislang nicht beschrieben.

Sie lassen sich herstellen, indem man

a) Verbindungen der Formel IIa und IIIa

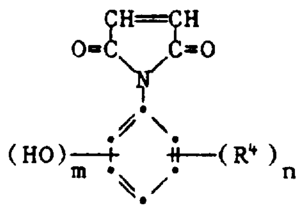 (IIa), 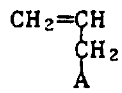 (IIIa),

worin $R^4$, A, m und n die weiter oben definierte Bedeutung besitzen, gegebenenfalls in Anwesenheit weiterer radikalisch polymerisierbarer Monomer radikalisch polymerisiert oder

b) Verbindungen der Formel IIb und IIIa

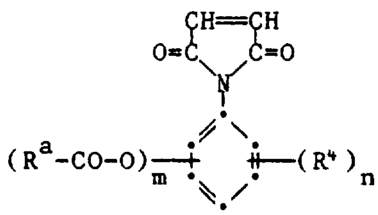 (IIb), 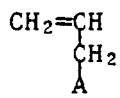 (IIIa),

worin $R^4$, A, m und n die schon weiter oben definierte Bedeutung besitzen und $R^a$ ein einwertiger Kohlenwasserstoffrest, bevorzugt $C_1$-$C_4$Alkyl, ist gegebenenfalls in Anwesenheit weiterer radikalisch polymerisierbarer Monomerer radikalisch polymerisiert und das Produkt durch Hydrolyse der $R^3$-CO- Gruppe in ein Copolymeres gemäss der weiter oben gegebenen Definition überführt.

Die Molekulargewichte der N-(Hydroxyphenyl)-maleinimid / Allyl-Copolymeren liegen in der Regel zwischen 500-100000 (Gewichtsmittel).

Die Verbindungen der Formeln IIa und IIb sind an sich bekannt oder können nach Standardreaktionen hergestellt werden. Nähere Einzelheiten dazu sind in der US-PS 4,289,699 zu finden. Die Allylverbindungen der Formel IIIa sind ebenfalls bekannt und teilweise im Handel erhältlich.

Bedeuten $R^1$, $R^2$, $R^3$, $R^4$, $R^6$ oder $R^8$ $C_1$-$C_4$Alkyl, so handelt es sich dabei um geradkettige oder verzweigte, bevorzugt um geradkettige, Alkylreste. Beispiele für solche Gruppen sind Methyl, Ethyl, n-Propyl, Isopropyl, n-Butyl oder sek.Butyl. Bevorzugt wird Methyl.

Als $C_1$-$C_4$Alkoxy besitzt der Alkylteil von $R^1$, $R^2$, $R^3$, $R^4$, $R^6$ oder $R^8$ die oben beispielhaft erwähnten Bedeutungen. Bevorzugt wird Methoxy.

Als Halogen sind $R^1$, $R^2$, $R^3$, $R^4$, $R^6$ oder $R^8$ Fluor, Chlor, Brom oder Iod. Bevorzugt wird Chlor oder Brom, insbesondere Brom.

Sind irgendwelche Reste $C_1$-$C_{20}$Alkyl, so handelt es sich dabei bevorzugt um geradkettige Gruppen. Es können aber auch verzweigte Alkylgruppen sein.

Beispiele für $C_1$-$C_{20}$Alkylreste sind Methyl, Ethyl, n-Propyl, Isopropyl, n-Butyl, sek.Butyl, tert.Butyl, n-Pentyl, Isopentyl, n-Hexyl, n-Heptyl, n-Octyl, 2-Ethylhexyl, n-Nonyl, n-Decyl, n-Undecyl, n-Dodecyl, n-Tetradecyl, n-Hexadecyl, n-Octadecyl oder n-Eicosyl. Bevorzugt werden $C_1$-$C_8$Alkylreste dieses Typs, insbesondere die geradkettigen und ganz

besonders Methyl oder Ethyl.

A als Halogen ist Fluor, Chlor, Brom oder Iod. Bevorzugt wird Chlor oder Brom, insbesondere Chlor.

Bei $R^{10}$, $R^{12}$ und $R^{13}$ als Cycloalkyl mit 5 bis 7 Ring C-Atomen handelt es sich in der Regel um Cyclopentyl, Cyclohexyl oder Cycloheptyl, insbesondere jedoch um Cyclohexyl. Diese Reste sind gegebenenfalls alkylsubstituiert.

Als gegebenenfalls substituiertes Aryl sind $R^{12}$ oder $R^{13}$ beispielsweise Phenyl oder Naphthyl. Als Substituenten kommen beispielsweise Alkylgruppen, insbesondere Methyl, Alkoxygruppen, insbesondere Methoxy, Halogenatome, insbesondere Chlor oder Brom, oder Cyanogruppen in Frage.

Spezifische Beispiele für substituierte Arylreste sind o-, m- oder p-Tolyl, Xylyl oder Chlorphenyl. Bevorzugter Arylrest ist Phenyl.

Als gegebenenfalls substituiertes Aralkyl sind $R^{12}$ oder $R^{13}$ beispielsweise Benzyl, α-Methylbenzyl oder α,α-Dimethylbenzyl. Auch hier kommen als Substituenten die oben für Aryl beispielhaft erwähnten Reste in Frage.

Spezifische Beispiele für substituierte Aralkylreste sind 4-Methylbenzyl oder 4-Methoxybenzyl. Bevorzugt wird Benzyl.

Der Index m im Strukturelement der Formel II ist vorzugsweise 1 oder 2, besonders bevorzugt 1. Der Index n im Strukturelement der Formel II ist vorzugsweise 0, 1 oder 2, besonders bevorzugt 0.

Die Komponente b1) der erfindungsgemässen Negativ-Resists enthält mindestens ein alkalisch-wässrig unter Salzbildung lösliches Phenol mit Epoxypropylseitengruppen und/oder eine lösliche Vinyletherverbindung, welche ein solches Ausmass an Hydroxylgruppen aufweisen, dass sie sich in ungehärtetem Zustand unter Salzbildung in einer alkalisch-wässrigen Lösung lösen lassen.

Falls gewünscht, kann eine Mischung von Epoxidharzen oder Vinylethern in den erfindungsgemässen Zusammensetzungen verwendet werden.

In der Regel sind diese Phenole mit Epoxypropylseitengruppen, oder diese Vinyletherverbindungen polyfunktionell. Es können auch kleinere Anteile an derartigen monofunktionellen Phenolen oder Vinyletherverbindungen in Kombination mit polyfunktionellen Phenolen mit Epoxypropylseitengruppen, oder mit Vinyletherverbindungen eingesetzt werden.

Bei der Komponente b1) kann es sich um relativ niedermolekulare Phenole mit Epoxypropylseitengruppen handeln; Diese Hydroxyl-Gruppen müssen in einem solchen Ausmass neben den Epoxidgruppen vorhanden sein, um die Löslichkeit in alkalisch-wässrigen Lösungen zu gewährleisten. Es kann sich aber auch um relativ hochmolekulare Verbindungen handeln, die neben den Epoxidgruppen oder Vinyletherresten einen zur Erzielung der Wasserlöslichkeit ausreichenden Anteil an Hydroxy-Gruppen besitzen.

Beispiele für Komponenten b1) sind Phenole mit Epoxypropylseitengruppen oder teilweise mit Glycidylgruppen veretherte Polyphenole, beispielsweise teilglycidylisierte Novolake auf Basis von Phenol und Formaldehyd oder auf Basis von Kresol und Formaldehyd.

Zu den bevorzugten Komponenten b1) zählen Verbindungen der Formel XI

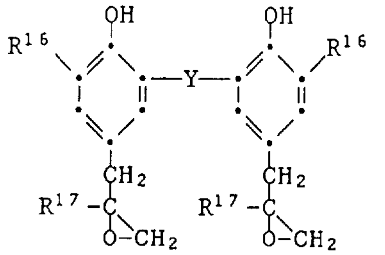

(XI),

worin $R^{16}$ $C_1$-$C_6$Alkyl ist, Y eine direkte C-C-Bindung darstellt oder eine Gruppe $-CH_2-$, $-CH(CH_3)-$, $-C(CH_3)_2-$, -O-, -S-, -CO- oder $-SO_2-$ bedeutet und $R^{17}$ Wasserstoff oder Methyl ist. Die Verbindungen der Formel XI sind neu und ebenfalls ein Gegenstand der vorliegenden Erfindung.

Weitere bevorzugte Komponenten b1) sind modifizierte o-Alkylphenol-Novolake der Formel XII

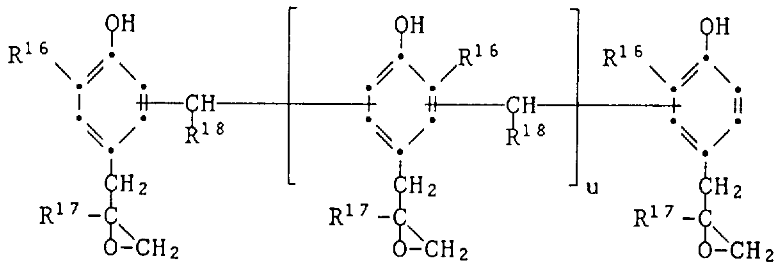

(XII),

worin $R^{16}$ und $R^{17}$ die oben definierte Bedeutung besitzen, $R^{18}$ Wasserstoff oder $C_1$-$C_6$Alkyl, insbesondere Methyl, ist und u 1 bis 6 bedeutet.

Weitere bevorzugte Komponenten b1) sind modifizierte Phenol-Novolake aus Struktureinheiten der Formeln XIII und XIV

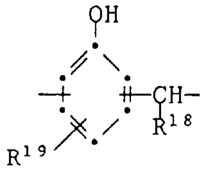 (XIII), 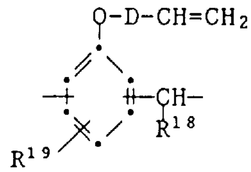 (XIV),

worin $R^{18}$ die oben definierte Bedeutung besitzt, $R^{19}$ Wasserstoff, $C_1$-$C_6$-Alkyl, Chlor oder Brom ist, D eine direkte C-C-Bindung oder eine -Alkylen-O-Gruppe mit 2-12 C-Atomen ist, und wobei der Anteil der Struktureinheiten der Formel XIII so gross ist, dass die unvernetzte Verbindung in einer alkalisch-wässrigen Lösung unter Salzbildung löslich ist.

Weitere bevorzugte Komponenten b1) sind modifizierte Poly-Hydroxystyrole aus Struktureinheiten der Formeln XV und XVI oder aus Struktureinheiten der Formeln XV und XVII

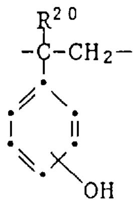 (XV), 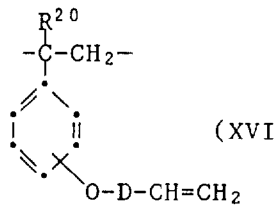 (XVI), 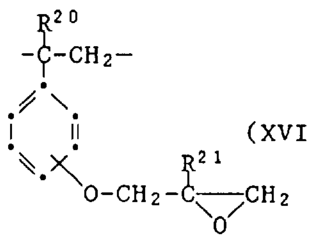 (XVII),

worin $R^{20}$ und $R^{21}$ unabhängig voneinander Wasserstoff oder Methyl sind, D die weiter oben definierte Bedeutung besitzt und wobei der Anteil der Struktureinheiten der Formel XV so gross ist, dass die unvernetzte Verbindung in einer alkalisch-wässrigen Lösung unter Salzbildung löslich ist.

Vorzugsweise handelt es sich bei diesen Verbindungen um modifizierte Poly-p-hydroxystyrole.

Die Herstellung von Phenolen mit Epoxypropylseitengruppen erfolgt beispielsweise durch Umsetzung von Allylphenolethern oder -estern, beispielsweise von Essigsäure-(2,6-diallylphenol)-ester, mit Persäuren, beispielsweise mit Peressigsäure, und anschliessender Verseifung.

Die Verbindungen der Formel XI lassen sich durch Epoxidierung der Diacetate der entsprechenden (Meth)allylverbindungen mit Persäuren und anschliessender Verseifung zum Bisphenol erhalten. Die (Meth)allylverbindungen lassen sich durch Claisen-Umlagerung der entsprechenden (Meth)allylether erhalten. Beispiele für solche Umsetzungen findet man in der EP-A-14,816.

Die Verbindungen der Formel XII lassen sich auf analoge Weise herstellen, indem man anstelle von den der Formel XI zugrundeliegenden Bisphenole von den der Formel XII zugrundeliegenden Novokalen ausgeht. Die Verbindungen enthaltend Stuktureinheiten der Formeln XIII und XIV lassen sich durch teilweise Veretherung der zugrundeliegenden Novolake mit Verbindungen der Typs $CH_2$=CH-D-Cl herstellen, wobei D die weiter oben definierte Bedeutung besitzt. Solche Umsetzungen sind in der JP-A-60-71,657 beschrieben.

Die Polyhydroxystyrole aus Struktureinheiten der Formel XV und XVI bzw. der Formel XV und XVII lassen sich aus den an sich bekannten Polyhydroxystyrolen durch teilweise Umsetzung der phenolischen Hydroxylgruppen mit Verbindungen des Typs $CH_2$=CH-D-Cl, wie oben definiert, oder mit Epichlorhydrin erhalten.

Als Komponente c1) bzw. b2) der erfindungsgemässen Gemische lässt sich eine Vielzahl bekannter und in der Technik erprobter kationischer Photoinitiatoren für Epoxidharze einsetzen. Dabei handelt es sich beispielsweise um Oniumsalze mit Anionen schwacher Nucleophilie. Beispiele dafür sind Haloniumsalze, wie unter Formel II in der EP-A 153,904 erwähnt, Iodosylsalze, wie unter Formel IV der EP-A 153,904 erwähnt, Sulfoniumsalze, wie unter Formel III der EP-A 153,904 erwähnt, Sulfoxoniumsalze, wie beispielsweise in den EP-A 35,969, 44,274, 54,509 und 164,314, beschrieben oder Diazoniumsalze, wie beispielsweise in der US-A-3,708,296 beschrieben.

Eine Uebersicht über weitere gängige Oniumsalzinitiatoren bietet "UV-Curing, Science and Technology" (Editor: S.P. Pappas, Technology Marketing Corp., 642 Westover Road, Stanford, Conneticut, USA).

Bevorzugte Photoinitiatoren sind Metallocensalze, wie beispielsweise in der EP-A 94,914 und ganz besonders in der EP-A 94,915 beschrieben.

Die Ausführungen in diesen Publikationen sind ebenfalls Gegenstand der vorliegenden Beschreibung.

Zu den bevorzugten Photoinitiatoren zählen die Verbindungen der Formeln XVIII, XIX und XX

$$\left[ R_h^{22}\!-\!I\!-\!R_j^{23} \right]^{\oplus} \left[ LQ_n \right]^{\ominus} \qquad (XVIII),$$

$$\left[ R^{24}\!-\!\overset{\overset{O}{\parallel}}{I}\!-\!R^{25} \right]^{\oplus} \left[ LQ_n \right]^{\ominus} \qquad (XIX),$$

$$\left[ R^{26}\!-\!\underset{R^{27}}{S}\!-\!R^{28} \right]^{\oplus} \left[ LQ_n \right]^{\ominus} \qquad (XX),$$

worin h = 1 und j = 1 ist oder h = 2 und j = 0 ist, und $R^{22}$ und $R^{23}$, im Falle h = 1 und j = 1, unabhängig voneinander einwertige carbocyclisch-aromatische $C_6$-$C_{18}$Reste sind, die gegebenenfalls ein bis drei Substituenten tragen, und $R^{22}$, im Falle h = 2 und j = 0, ein zweiwertiger carbocyclisch-aromatischer $C_{12}$-$C_{18}$Rest ist, der gegebenenfalls ein bis drei Substituenten trägt, $R^{24}$, $R^{25}$, $R^{26}$, $R^{27}$ und $R^{28}$ unabhängig voneinander eine der Bedeutungen von $R^{23}$ annehmen, L ausgewählt wird aus der Gruppe bestehend aus B, P, As und Sb, Q ein Halogenatom ist oder ein Teile der Reste Q in einem Anion $LQ_n^-$ auch Hydroxylgruppen sein kann und n eine ganze Zahl ist, die der um Eins vergrösserten Wertigkeit von L entspricht.

Beispiele für einwertige carbocyclisch-aromatische $C_6$-$C_{18}$Reste sind Phenyl, Naphthyl, Anthryl und Phenanthryl. Bevorzugt wird Phenyl. Gegebenenfalls vorliegende Substituenten dieser Reste sind Alkyl, bevorzugt $C_1$-$C_6$Alkyl, wie Methyl, Ethyl, n-Propyl, Isopropyl, n-Butyl, n-Pentyl oder n-Hexyl, Alkoxy, bevorzugt $C_1$-$C_6$Alkoxy, wie Methoxy, Ethoxy, n-Propoxy, n-Butoxy, n-Pentoxy oder n-Hexoxy, Alkylthio, bevorzugt $C_1$-$C_6$Alkylthio, wie Methylthio, Ethylthio, Propylthio, Butylthio, Pentylthio oder Hexylthio, Halogen, wie Fluor, Chlor, Brom oder Iod, Aminogruppen, Cyanogruppen, Nitrogruppen oder Arylthio, wie Phenylthio.

Beispiele für zweiwertige carbocyclisch-aromatische $C_{12}$-$C_{18}$Reste sind Biphenyl-2,2′-diyl.

Beispiele für bevorzugte Halogenatome Q sind Chlor oder insbesondere Fluor. Bevorzugte Anionen $LQ_n^-$ sind $BF_4^-$, $PF_6^-$, $AsF_6^-$, $SbF_6^-$ und $SbF_5(OH)^-$.

Zu den ganz besonders bevorzugten Metalloceninitiatoren im Rahmen dieser Erfindung zählen die Verbindungen der Formel XXI

$$\left[ R^{29}(Fe^{II}R^{30})_s \right]_t^{+s} \left[ X \right]_s^{-t} \qquad (XXI),$$

worin s 1 oder 2 bedeutet, t 1, 2 3, 4 oder 5 ist, X für ein nicht nukleophiles Anion steht, $R^{29}$ ein $\pi$-Aren ist und $R^{30}$ ein Anion eines $\pi$-Arens, bevorzugt ein Cyclopentadienylanion, bedeutet.

Beispiele für $\pi$-Arene $R^{29}$ und Anionen von $\pi$-Arenen $R^{30}$ findet man in der EP-A 94,915.

Beispiele für bevorzugte $\pi$-Arene $R^{29}$ sind Toluol, Xylol, Ethylbenzol, Cumol, Methoxybenzol, Methylnaphthalin, Methoxynaphthalin, Pyren, Perylen, Stilben, Diphenylenoxid und Diphenylensulfid.

Ganz besonders bevorzugt man Cumol, Methylnaphthalin oder Stilben.

Beispiele für nicht nukleophile Anionen $X^-$ sind $FSO_3^-$, Anionen von organischen Sulfonsäuren, von Carbonsäuren oder Anionen $[LQ_n]^-$, wie oben definiert.

Bevorzugte Anionen leiten sich ab von teilfluor- oder perfluoraliphatischen oder teilfluor- oder perfluoraromatischen Carbonsäuren, oder insbesondere von teilfluor- oder perfluoraliphatischen oder von teilfluor- oder perfluoraromatischen organischen Sulfonsäuren oder es handelt sich bevorzugt um Anionen $[LQ_n]^-$.

Beispiele für Anionen X sind $BF_4^-$, $PF_6^-$, $AsF_6^-$, $SbF_6^-$, $SbF_5OH^-$, $CF_3SO_3^-$, $C_2F_5SO_3^-$, n-$C_3F_7SO_3^-$, n-$C_4F_9SO_3^-$, n-$C_6F_{13}SO_3^-$, n-$C_8F_{17}SO_3^-$, $C_6F_5SO_3^-$, Phosphorwolframat ($PO_{40}W_{12}^{3-}$) oder Siliciumwolframat ($SiO_{40}W_{12}^{4-}$).

Bevorzugt werden $PF_6^-$, $AsF_6^-$, $SbF_6^-$, $CF_3SO_3^-$, $C_2F_5SO_3^-$, n-$C_3F_7SO_3^-$, n-$C_4F_9SO_3^-$, n-$C_6F_{13}SO_3^-$ und n-$C_8F_{17}SO_3^-$.

Man kann auch Kombinationen dieser Metallocensalze mit Oxidationsmitteln einsetzen. Solche Kombinationen sind in der EP-A 126,712 beschrieben.

Zur Erhöhung der Lichtausbeute setzt man, je nach Initiatortyp, vorzugsweise Sensibilisatoren zu.

Beispiele dafür sind polycyclische aromatische Kohlenwasserstoffe oder aromatische Ketoverbindungen. Spezifische Beispiele bevorzugter Sensibilisatoren sind in der EP-A 153,904 erwähnt.

Die erfindungsgemässe Mischung kann noch weitere in der Technik der Negativ-Resists übliche Zusätze d1) bzw. c2) enthalten. Beispiele für solche Zusätze sind Netzmittel, Verlaufsmittel, Stabilisatoren, Farbstoffe, Pigmente, Füllstoffe, Haftvermittler, Weichmacher und Zusatzharze. Zusatzharze werden im allgemeinen verwendet, um die mechanischen Eigenschaften der Schicht zu modifizieren. Beispiele dafür sind Vinyl-copolymere auf Styrol- oder Acrylatbasis,

Polyester, Polyamide oder Silikonharze. Diese Zusatzharze werden in der Regel in kleinen Mengen, bevorzugt bis 10 Gew.%, bezogen auf die Gesamtmischung, zugesetzt. Sie müssen mit den übrigen Bestandteilen der Mischung verträglich sein und sollten in organischen Lösungsmitteln löslich sein.

Ferner können den Mischungen noch Katalysatoren, Beschleuniger und Härter für die Epoxidkomponente beigegeben werden. Diese Zusätze bewirken bei einer eventuellen thermischen Nachbehandlung eine Nachhärtung der Epoxidkomponente; gegebenenfalls erfolgt dieser Nachhärtungsschritt nach der Entwicklung des Photoresists.

Die erfindungsgemässen Massen enthalten bevorzugt 10-90 Gew.% des Bindemittels a1), 5-80 Gew.% des Epoxy-Phenols oder Vinylethers b1), 0,5-20 Gew.% des Photoinitiators c1) und 0-15 Gew.% der Zusatzstoffe d1). Dabei ergänzen sich die Anteile der einzelnen Komponenten jeweils zu 100 % und die Mengenangaben sind auf die Gesamtmenge bezogen.

Ganz besonders bevorzugt enthalten die Massen, bezogen auf die Gesamtmenge, 30-85 Gew.% Bindemittel a1), 10-60 Gew.% Epoxy-Phenol- oder Vinyletherverbindung b1), 1-10 Gew.% Photoinitiator c1) und 0-10 Gew.% Zusatzstoffe d1).

Der Anteil der Komponenten a2), b2) und c2) beträgt vorzugsweise 99-70 Gew.%, 1-20 Gew.% und 0-10 Gew.-%, bezogen auf die Menge an a2), b2) und c2).

Zur Herstellung von Beschichtungen löst man die einzelnen Komponenten in einem geeigneten Lösungsmittel. Die Wahl des Lösungsmittels und die Konzentration richtet sich hauptsächlich nach der Art der Komponenten und nach dem Beschichtungsverfahren. Das Lösungsmittel soll inert sein, d.h. es soll mit den Komponenten keine chemische Reaktion eingehen und es soll bei der Trocknung nach dem Beschichten wieder entfernt werden können.

Bekannte Beschichtungsverfahren sind z.B.: Schleudern, Tauchen, Rakelbeschichtung, Vorhanggiessverfahren, Aufpinseln, Sprühen oder Reverse-Rollbeschichtung.

Ferner kann die erfindungsgemässe Zusammensetzung als Dry-film von einem temporären, flexiblen Träger auf ein Substrat übertragen werden. Ein solches Verfahren ist z.B. in der EP-A 153,904 beschrieben.

Die Auftragsmenge (Schichtdicke) und Art des Substrates (Schichtträger) sind abhängig vom gewünschten Applikationsgebiet. Besonders vorteilhaft ist es, dass die erfindungsgemässen Zusammensetzungen in weit variablen Schichtdicken eingesetzt werden können. Dieser Schichtdickenbereich umfasst Werte von ca. 0,5 µm bis mehr als 100 µm.

Mögliche Einsatzgebiete der erfindungsgemässen Zusammensetzungen sind die Verwendung als Photoresists für die Elektronik (Galvanoresist, Aetzresist, Lötstoppresist), die Herstellung von Druckplatten, wie Offsetdruckplatten oder Siebdruckformen, der Einsatz beim Formteilätzen oder der Einsatz als Mikroresist bei der Herstellung integrierter Schaltkreise.

Dementsprechend unterschiedlich sind die möglichen Schichtträger und die Verarbeitungsbedingungen der beschichteten Substrate.

Für photographische Informationsaufzeichnung dienen z.B. Folien aus Polyester, Celluloseacetat oder mit Kunststoff beschichtete Papiere; für Offsetdruckformen speziell behandeltes Aluminium und für die Herstellung gedruckfer Schaltungen kupferkaschierte Laminate. Die Schichtdicken für photographische Materialien und Offsetdruckformen betragen bevorzugt ca. 0,5 bis 10 µm; für gedruckte Schaltungen 1 bis ca. 100 µm.

Nach dem Beschichten wird das Lösungsmittel in der Regel durch Trocknen entfernt und es resultiert eine Schicht des Photoresist auf dem Träger.

Die Lichtempfindlichkeit der erfindungsgemässen Zusammensetzungen reicht in der Regel vom UV-Gebiet (ca. 200 nm) bis ca. 600 nm und umspannt somit einen sehr breiten Bereich. Als Lichtquellen kommen daher eine grosse Anzahl der verschiedensten Typen zur Anwendung. Es sind sowohl Punktquellen als auch flächenförmige Strahler (Lampenteppiche) geeignet. Beispiele sind: Kohlelichtbogenlampen, Xenon-Lichtbogenlampen, Quecksilberdampflampen, gegebenenfalls mit Metall-Halogeniden dotiert (Metall-Halogenlampen), Fluoreszenzlampen, Argonglühlampen, Elektronenblitzlampen und photographische Flutlichtlampen.

Der Abstand zwischen Lampe und erfindungsgemässem Bildmaterial kann je nach Anwendungszweck und Lampentyp bzw. -stärke variieren, z.B. zwischen 2 cm bis 150 cm. Spezielle geeignet sind Laserlichtquellen, z.B. Argonionenlaser oder Kryptonionenlaser mit starken Emissionslinien (Ar-Laser) bei 457, 476, 488, 514, 528 nm. Bei dieser Art der Belichtung ist keine Photomaske im Kontakt mit der Photopolymerschicht mehr nötig; der gesteuerte Laser-Strahl schreibt direkt auf die Schicht. Hier ist die hohe Empfindlichkeit der erfindungsgemässen Materialien sehr vorteilhaft, die hohe Schreibgeschwindigkeiten bei relativ niedrigen Intensitäten erlaubt. Nach dieser Methode können gedruckte Schaltungen in der Elekfronikindustrie, lithographische Offsetdruckplatten oder Reliefdruckplatten sowie photographische Bildaufzeichnungsmaterialien hergestellt werden.

Nach der bildmässigen Belichtung des Materials und vor der Entwicklung kann es vorteilhaft sein, eine thermische Behandlung für kürzere Zeit durchzuführen. Dabei werden nur die bereits belichteten Teile thermisch nachgehärtet. Diese thermische Behandlung ist besonders empfehlenswert bei den Metallocen-Photoinitiatoren. Sie kann in konventionellen Oefen, beispielsweise in Konvektionsöfen, stattfinden, aber auch mit IR-Strahlung, beispielsweise durch Bestrahlung mit IR-Lasern, oder in Mikrowellengeräten erfolgen. Die angewandten Temperaturen liegen im allgemeinen

bei 50-150°C, bevorzugt bei 80-130°C; die Härtungszeit liegt in der Regel zwischen 1 und 15 Minuten.

Nach der Belichtung und gegebenenfalls thermischen Nachbehandlung werden die unbelichteten Stellen des Photolackes in an sich bekannter Weise mit einem Entwickler entfernt.

Besonders bevorzugt als Entwickler werden wässrig alkalische Lösungen, wie sie auch für die Entwicklung von Naphthodiazidchinonschichten eingesetzt werden. Dazu zählen insbesondere Lösungen von Alkalimetallsilikaten, -phosphaten und -hydroxiden und -carbonaten. Diesen Lösungen können gegebenenfalls noch kleinere Mengen an Netzmitteln und/oder organischen Lösungsmitteln zugesetzt sein.

Entwicklung mit organischen Lösungsmitteln ist ebenfalls möglich. In Frage kommen beispielsweise Cyclohexanon, 2-Ethoxyethanol, Aceton, MEK sowie Mischungen dieser Lösungsmittel.

Nach der Belichtung und Entwicklung kann das Reliefbild nochmals einer thermischen Behandlung unterworfen werden (thermisch Nachhärtung 2. Stufe). Dabei reagieren verbliebene Epoxidgruppen oder Vinylethergruppen mit den phenolischen Hydroxylgruppen des Binders oder polymerisieren mit sich selbst. Dazu können die in der Epoxidharzchemie üblichen Katalysatoren und Beschleuniger bereits bei der Beschichtung zugesetzt werden (Komponente d1 bzw. c2), sie dürfen allerdings die Belichtung nicht stören.

Durch diese zusätzliche thermische Netzwerkbildung werden besonders resistente und dauerhafte Reliefbilder erhalten, die sich, wie auch Beschichtungen gehärteter Epoxidharze, durch gute thermomechanische, chemische und elektrische Eigenschaften, insbesondere Stabilität, Haftung und hohen spezifischen Durchgangswiderstand auszeichnen.

Die Erfindung betrifft daher auch ein Verfahren zur Erzeugung von Reliefstrukturen umfassend folgende Arbeitsschritte:

a) Beschichten eines Substrates mit einer strahlungsempfindlichen Zusammensetzung, wie oben definiert,
b) Belichten des beschichteten Substrates mit einem vorbestimmten Muster aktinischer Strahlung, gegebenenfalls
c) thermische Nachbehandlung,
d) Entwicklungsstufe und
e) gegebenenfalls thermische Nachbehandlung des entwickelten Systems.

Der Begriff 'Belichtung mit einem vorbestimmten Muster atkinischer Strahlung' beinhaltet sowohl die Belichtung durch eine Photomaske, die ein vorbestimmtes Muster enthält, beispielsweise ein Diapositiv, sowie die Belichtung durch einen Laserstrahl, der beispielsweise computergesteuert über die Oberfläche des beschichteten Substrates bewegt wird und auf diese Weise ein Bild erzeugt.

Ferner betrifft die Erfindung ein Verfahren zur Herstellung von Schutzschichten umfassend folgende Arbeitsschritte:

a) Beschichten eines Substrates mit einer strahlungsempfindlichen Zusammensetzung, wie oben definiert,
b) Belichten der strahlungsempfindlichen Schicht in ihrer gesamten Fläche und
c) gegebenenfalls thermische Nachbehandlung des belichteten Systems.

Darüber hinaus betrifft die Erfindung die Verwendung der oben definierten Zusammensetzungen zur Herstellung von Schutzschichten und Reliefstrukturen.

Die folgenden Beispiele erläutern die Erfindung:

A) Herstellungsbeispiele

Beispiel 1: Herstellung von 2,2'-Dihydroxy-3,3'-dimethyl-5,5'-(2,3-epoxypropyl)-diphenylmethan

1.1. Herstellung von 2,2'-Dihydroxy-3,3'-dimethyl-5,5'-diallyl-diphenyl-methan

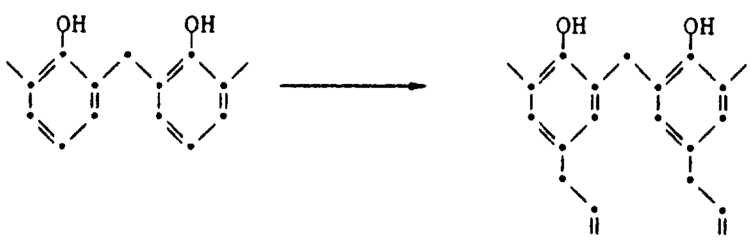

1 2

Zu 45,6 g (0,2 Mol) 2,2'-Dihydroxy-3,3'-dimethyl-diphenylmethan 1 (hergestellt nach G. Casiraglie et al., Synthesis, 1981, 143) und 93,2 g (0,68 Mol) $K_2CO_3$ in 160 ml DMF werden bei 70°C 51,4 g (0,68 Mol) Allylchlorid innerhalb von 45 Min. zugetropft. Nach 3 h wird das Reaktionsgemisch filtriert und das Lösungsmittel abdestilliert. Der Rückstand wird 18 h bei 160°C gerührt. Es werden 58,1 g (94 %) rohes Produkt 2 erhalten, welches zweimal aus 50 ml Hexan umkristallisiert wird. Man erhält 39,0 g (63 %) 2 als beige Kristalle mit einem Smp. von 89-91°C.

1.2. Herstellung des Diacetats von 2

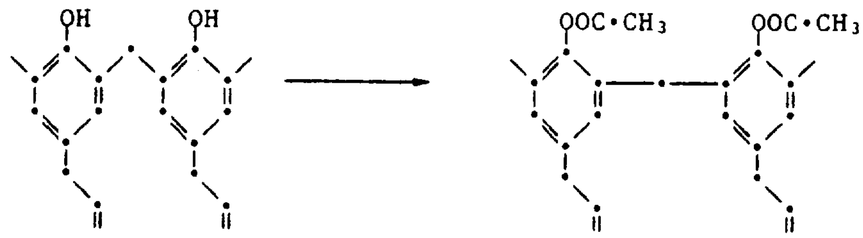

2 3

Zu einer Lösung von 38,8 g (0,12 Mol) 5,5'-Diallyl-2,2'-dihydroxy-3,3'-dimethyl-diphenylmethan 2 und 0,3 g Dimethylaminopyridin in 120 ml Pyridin werden bei Raumtemperatur innerhalb von 20 Min. 60 ml Essigsäureanhydrid getropft. Nach 30 Minuten wird das Reaktionsgemisch auf 350 ml $H_2O$ gegossen und 4mal mit 100 ml Essigsäureethylester extrahiert. Die vereinigten org. Phasen werden sechsmal mit 100 ml $H_2O$ gewaschen, über $MgSO_4$ getrocknet, filtriert und eingedampft. Man erhält 46,9 g (95 %) 3 als klare braune Flüssigkeit, welche ohne Reinigung weiterverwendet wird. $\eta^{80°C}$ = 110 mPa·s.

1.3. Epoxidierung des Diacetats 3

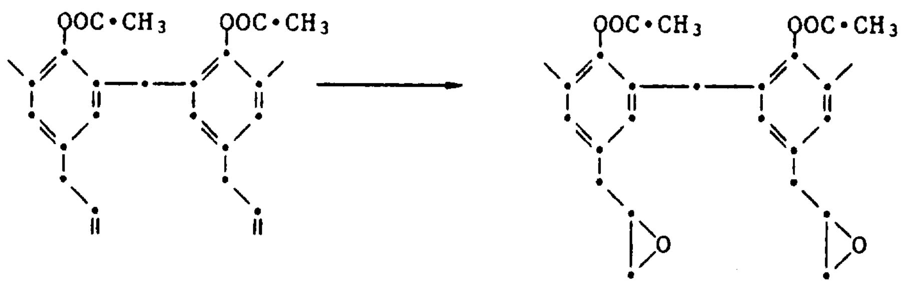

3 4

Zu 16,7 g (43 mMol) 2,2'-Diacetoxy-5,5'-diallyl-3,3'-dimethyldiphenylmethan 3 und 2,7 g Natriumacetat in 100 ml $CH_2Cl_2$ werden innerhalb von 30 Min. bei 30°C 24,3 g (0,13 Mol) 40 % Peressigsäure in Eisessig getropft. Nach 20 h wird das Reaktionsgemisch abgekühlt, 2x mit 25 ml $H_2O$, 1x mit 25 ml 1N NaOH, 2x mit 25 ml 10 % $NH_4Cl$-Lösung und 1x mit 25 ml $H_2O$ gewaschen, über $MgSO_4$ getrocknet, über $Na_2SO_3$ peroxidfrei gemacht, filtriert und eingedampft. Man erhält 17,5 g (96 %) 4 als klare, gelbe Flüssigkeit, welche ohne Reinigung weiterverwendet wird, $\eta^{80°C}$ = 270 mPa·s; Epoxidzahl: 4,0 Val/kg (85 %).

1.4. Verseifung des Diacetats 4

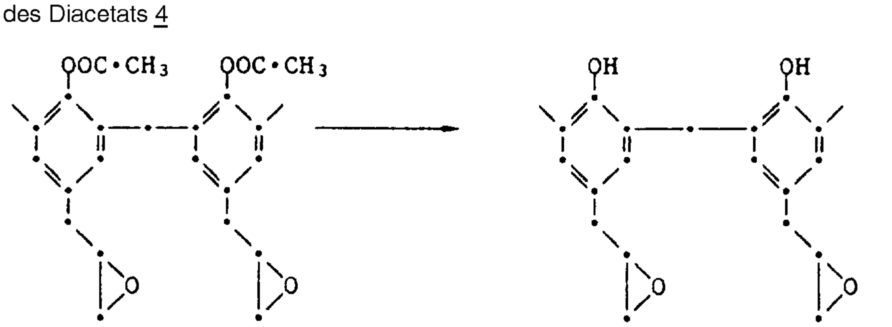

4 5

Zu 16,1 g (38 mMol) 2,2'-Diacetoxy-5,5'-diepoxypropyl-3,3'-dimethyldiphenylmethan 4 in 100 ml abs. Methanol werden bei 0°C innerhalb von 15 Min. in drei Portionen 16,1 g $K_2CO_3$ zugegeben. Nach 20 Min. wird das Reaktionsgemisch filtriert, mit 100 ml $H_2O$ versetzt und mit 10 % $NaHSO_4$-Lösung auf pH 6 gestellt. Das ausgefallene Produkt wird abfiltriert und mit $H_2O$ gewaschen. Man erhält 11,5 g (89 %) 5 als beige Kristalle. Smp. 117-119°C; Epoxidzahl: 5,2 Val/kg (88 %).

B) Anwendungsbeispiele

Beispiel I:

Eine Lösung bestehend aus 2,5 g 2,2'-Dihydroxy-3,3'-dimethyl-5,5'-(2,3-epoxypropyl)-diphenylmethan; 5 g Cyclohexanon; 2,5 g eines p-Vinylphenol-polymer mit einem $\bar{Mw}$ 10'000; 0,1 g ($\eta^6$ Cumol)-($\eta^5$ cyclopentadienyl)-eisen II hexafluoroantimonat und 0,5 g Isopropylthioxanthon wird mit einem 100 µ Rakel auf ein kupferkaschiertes Epoxylaminat gebracht. Nach 10' Trocknung bei 100 Grad erhält man einen Film von 30 µ Dicke, welcher photostrukturierbar ist. Der Film wird mit einer 5000 W Metallhalogenidlampe (Abstand 50 cm) durch einen 21 Step Stouffer Sensitivity Guide belichtet und anschliessend 20' bei 110 Grad gehärtet. Nach Entwicklung in einer Lösung bestehend aus 37,5 g Natriummethasilikat * 5 $H_2O$ in 1000 ml Wasser erhält man folgende Stufenzahlen:

| | | | |
|---|---|---|---|
| Belichtungszeit: | 15" | 45" | 120" |
| Stufenzahl: | 2 | 4 | 6 |

**Patentansprüche**

**1.** Kationisch photopolymerisierbare Zusammensetzung bestehend im wesentlichen aus

a1) mindestens einem festen, filmbildenden Polyphenol,
b1) mindestens einem Phenol mit Epoxypropylseitengruppen und/oder einer polyfunktionellen Vinyletherverbindung, welche ein solches Ausmassan Hydroxylgruppen aufweisen, dass sie sich in ungehärtetem Zustand unter Salzbildung in einer alkalisch-wässrigen Lösung lösen lassen,
c1) mindestens einem Oniumsalz mit einem Anion mit schwacher Nucleophilie oder einem Mettallocensalz als kationischen Photoinitiator für die Komponente b1) und gegebenenfalls
d1) üblichen Zusätzen.

**2.** Zusammensetzung gemäss Anspruch 1, worin das Bindemittel a1) ausgewählt wird aus der Gruppe bestehend aus

i) Novolaken aus mindestens einem Phenol und mindestens einem Aldehyd,
ii) Homo- und Copolymeren von Alkenylphenolen und
iii) Homo- und Copolymeren von N-Hydroxyphenylmaleinimiden.

**3.** Zusammensetzung gemäss Anspruch 2, worin
der Novolak i) sich ableitet von einem zweikernigen oder einkernigen gegebenenfalls substituierten Phenol und einem $C_1$-$C_6$Aldehyd oder das Homo- oder Copolymere von Alkenylphenolen ii) das Strukturelement der Formel I enthält

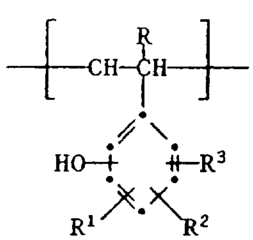

(I),

worin R Wasserstoff oder Methyl ist, $R^1$, $R^2$ und $R^3$ unabhängig voneinander Wasserstoff, $C_1$-$C_4$Alkyl, $C_1$-$C_4$Alkoxy, Halogen und Methylol bedeuten, oder
das Homo- oder Copolymere von N-Hydroxyphenylmaleinimid iii) das Strukturelement der Formel II enthält

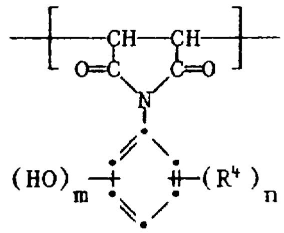

(II),

worin $R^4$ $C_1$-$C_4$Alkyl, $C_1$-$C_4$Alkoxy oder Halogen ist, m 1 oder 2 darstellt, n 0, 1, 2, 3 oder 4 ist und die Summe von m und n höchstens 5 bedeutet, wobei die Reste $R^4$ eines Phenylkernes innerhalb der gegebenen Definitionen unterschiedlich sein können.

**4.** Zusammensetzung gemäss Anspruch 3, worin das Bindemittel ii) ein Copolymeres auf Basis von Alkenylphenolen und carboxylgruppenfreien Vinylverbindungen ist oder
das Bindemittel iii) ein Copolymeres auf Basis von N-Hydroxyphenylmaleinimid und carboxylgruppenfreien Vinylverbindungen ist.

**5.** Zusammensetzung gemäss Anspruch 1, worin Komponente b1) eine Verbindung der Formel XI ist

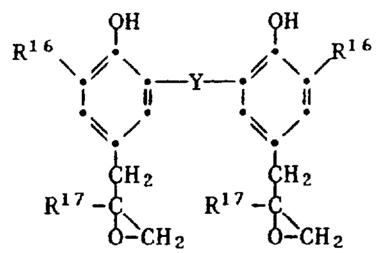

(XI),

worin $R^{16}$ $C_1$-$C_6$Alkyl ist, Y eine direkte C-C-Bindung darstellt oder eine Gruppe $-CH_2-$, $-CH(CH_3)-$, $-C(CH_3)_2-$, -O-, -S-, -CO- oder $-SO_2-$ bedeutet und $R^{17}$ Wasserstoff oder Methyl ist; oder worin Komponente b1) ein modifizierter o-Alkylphenol-Novolak der Formel XII ist

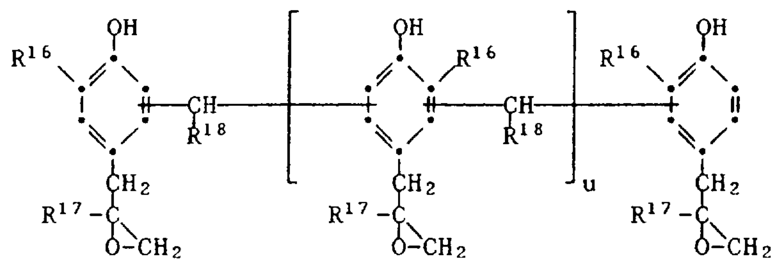

(XII),

worin $R^{16}$ und $R^{17}$ die oben definierte Bedeutung besitzen, $R^{18}$ Wasserstoff oder $C_1$-$C_6$Alkyl ist und u 1 bis 6 bedeutet.

**6.** Zusammensetzung gemäss Anspruch 1, worin Komponente b1) ein modifizierter Phenol-Novolak aus Struktureinheiten der Foremln XIII und XIV ist

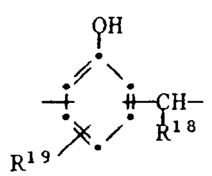

(XIII),

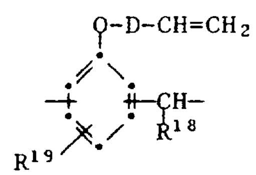

(XIV),

worin $R^{18}$ die in Anspruch 6 definierte Bedeutung besitzt, $R^{19}$ Wasserstoff, $C_1$-$C_6$-Alkyl, Chlor oder Brom ist, D eine direkte C-C-Bindung oder eine -Alkylen-O-Gruppe mit 2-12 C-Atomen ist, und wobei der Anteil der Struktureinheiten der Formel XIII so gross ist, dass die unvernetzte Verbindung in einer alkalisch-wässrigen Lösung unter Salzbildung löslich ist; oder worin Komponente b1) ein modifiziertes Poly-Hydroxystyrol aus Struktureinheiten der Formel XV und XVI oder aus Struktureinheiten der Formel XV und XVII ist

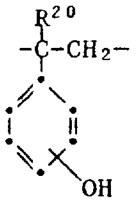 (XV), 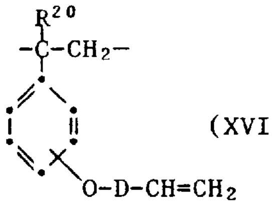 (XVI), 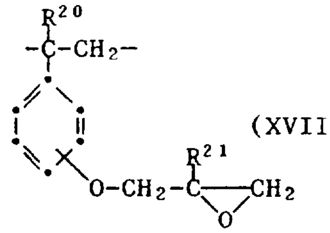 (XVII),

worin $R^{20}$ und $R^{21}$ unabhängig voneinander Wasserstoff oder Methyl sind, D die oben definierte Bedeutung besitzt und wobei der Anteil der Struktureinheiten der Formel XV so gross ist, dass die unvernetzte Verbindung in einer alkalisch-wässrigen Lösung unter Salzbildung löslich ist.

**7.** Zusammensetzung gemäss den Anspruch 1, worin der Photoinitiator c1) eine Verbindung der Formel XVIII ist

$$\left[ R^{29}(Fe^{II}R^{30})_s \right]^{+s}_t \left[ X \right]^{-t}_s \qquad (XVIII),$$

worin s 1 oder 2 bedeutet, t 1, 2, 3, 4 oder 5 ist, X für ein nicht nukleophiles Anion steht, $R^{29}$ ein $\pi$-Aren ist und $R^{30}$ ein Anion eines $\pi$-Arens bedeutet.

**8.** Verbindungen der Formel XI

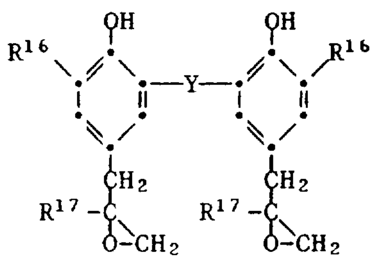 (XI),

worin Y, $R^{16}$ und $R^{17}$ die in Anspruch 5 definierte Bedeutung besitzen.

**9.** Verfahren zur Erzeugung von Reliefstrukturen umfassend folgende Arbeitsschritte:

a) Beschichten eines Substrates mit einer strahlungsempfindlichen Zusammensetzung gemäss den Anspruch 1,
b) Belichten des beschichteten Substrates mit einem vorbestimmten Muster aktinischer Strahlung, gegebenenfalls
c) thermische Nachbehandlung,
d) Entwicklungsstufe und gegebenenfalls
e) thermische Nachbehandlung des entwickelten Systems.

**10.** Verfahren zur Erzeugung von Schutzschichten umfassend folgende Arbeitsschritte:

a) Beschichten eines Substrates mit einer strahlungsempfindlichen Zusammensetzung gemäss den Anspruch 1,
b) Belichten der strahlungsempfindlichen Schicht in ihrer gesamten Fläche und
c) gegebenenfalls thermische Nachbehandlung.

**11.** Verwendung der Zusammensetzung gemäss den Anspruch 1 zur Herstellung von Schutzschichten und Reliefstrukturen.

## Claims

**1.** A cationically photopolymerizable composition essentially comprising

a1) at least one solid, film-forming polyphenol,
b1) at least one phenol having epoxypropyl side groups and/or one polyfunctional vinyl ether compound, which have an amount of hydroxyl groups which is such that they can be dissolved, in the uncured state, in an aqueous alkaline solution with salt formation,
c1) at least one onium salt with an anion of weak nucleophilicity or a metallocene salt as cationic photoinitiator for component b1) and, if desired,
d1) customary additives.

**2.** A composition according to claim 1, in which the binder al) is selected from the group consisting of

i) novolaks prepared from at least one phenol and at least one aldehyde,
ii) homopolymers and copolymers of alkenylphenols, and
iii) homopolymers and copolymers of N-hydroxyphenylmaleimides.

**3.** A composition according to claim 2, in which the novolak i) is derived from a dinuclear or mononuclear substituted or unsubstituted phenol and a $C_1$-$C_6$aldehyde or in which the homopolymer or copolymer of alkenylphenols ii) contains the structural element of the formula I

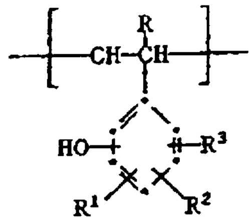

(I),

in which R is hydrogen or methyl, $R^1$, $R^2$ and $R^3$, independently of one another, are hydrogen, $C_1$-$C_4$alkyl, $C_1$-$C_4$alkoxy, halogen or methylol, or in which the homopolymer or copolymer of N-hydroxyphenylmaleimide iii) contains the structural element of the formula II

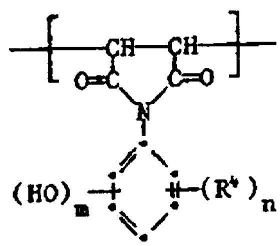

(II),

in which $R^4$ is $C_1$-$C_4$alkyl, $C_1$-$C_4$alkoxy or halogen, m is 1 or 2, n is 0, 1, 2, 3 or 4, and the sum of m and n is a maximum of 5, it being possible for the radicals $R^4$ of a phenyl ring to be different within the definitions given.

**4.** A composition according to claim 3, in which the binder ii) is a copolymer based on alkenylphenols and vinyl compounds which are free of carboxyl groups or the binder iii) is a copolymer based on N-hydroxyphenylmaleimide and vinyl compounds which are free of carboxyl groups.

**5.** A composition according to claim 1, in which component b1) is a compound of the formula XI

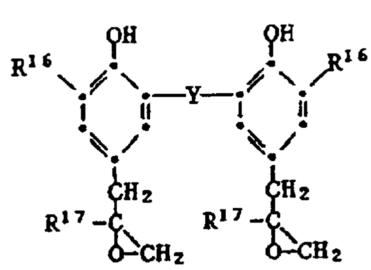

(XI),

in which $R^{16}$ is $C_1$-$C_6$alkyl, Y is a direct C-C bond or a $-CH_2-$, $-CH(CH_3)-$, $-C(CH_3)_2-$, -O-, -S-, -CO-, or $-SO_2-$ group, and $R^{17}$ is hydrogen or methyl; or in which component b1) is a modified o-alkylphenol novolak of the formula XII

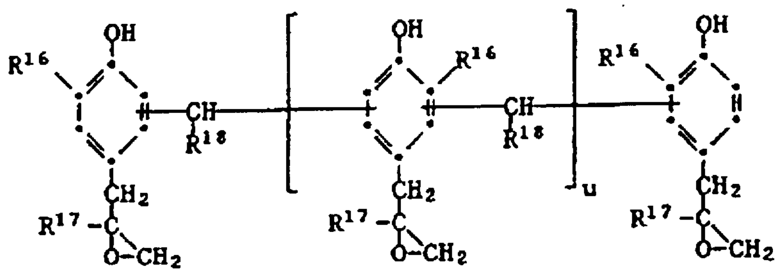 (XII),

in which $R^{16}$ and $R^{17}$ are as defined above, $R^{18}$ is hydrogen or $C_1$-$C_6$alkyl and u is 1 to 6.

**6.** A composition according to claim 1, in which component b1) is a modified phenol novolak comprising structural units of the formulae XIII and XIV

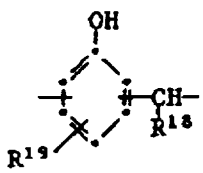 (XIII), 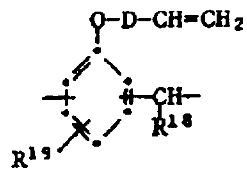 (XIV),

in which $R^{18}$ is as defined in claim 5, $R^{19}$ is hydrogen, $C_1$-$C_6$alkyl, chlorine or bromine, D is a direct C-C bond or an -alkylene-O- group having 2-12 C atoms, and where the number of structural units of the formula XIII is sufficiently large for the uncrosslinked compound to be soluble in an aqueous alkaline solution with salt formation; or in which component b1) is a modified polyhydroxystyrene comprising structural units of the formula XV and XVI or structural units of the formula XV and XVIII

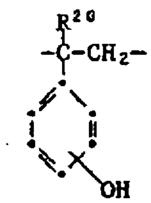 (XV), 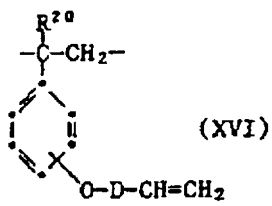 (XVI), 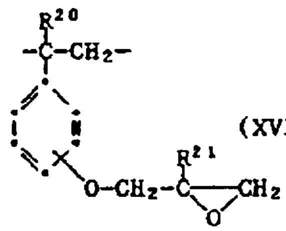 (XVII),

in which $R^{20}$ and $R^{21}$, independently of one another, are hydrogen or methyl, D is as defined above, and where the number of structural units of the formula XV is sufficiently large for the uncrosslinked compound to be soluble in an aqueous alkaline solution with salt formation.

**7.** A composition according to claim 1, in which the photoinitiator c1) is a compound of the formula XVIII

$$\left[ R^{29} (Fe^{II} R^{30})_s \right]_t^{+s} \left[ X \right]_s^{-t} \qquad \text{(XVIII)},$$

in which s is 1 or 2, t is 1, 2, 3, 4 or 5, X is a non-nucleophilic anion, $R^{29}$ is a $\pi$-arene and $R^{30}$ is an anion of a $\pi$-arene.

**8.** A compound of the formula XI

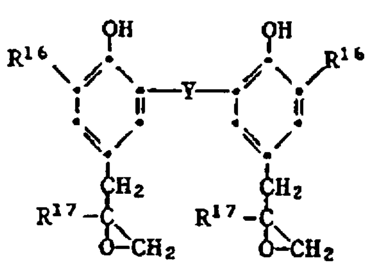 (XI),

in which Y, $R^{16}$ and $R^{17}$ are as defined in claim 5.

**9.** A process for producing relief structures and comprising the following steps:

a) coating of a substrate with a radiation-sensitive composition according to claim 1,
b) exposure of the coated substrate with a predetermined pattern of actinic radiation, if desired
c) thermal aftertreatment,
d) development step and, if desired,
e) thermal aftertreatment of the developed system.

**10.** A process for producing protective coatings, comprising the following steps:

a) coating of a substrate with a radiation-sensitive composition according to claim 1,
b) exposure of the radiation-sensitive coating over its entire surface, and
c) thermal aftertreatment, if desired.

**11.** The use of a composition according to claim 1 for the production of protective coatings and relief structures.

## Revendications

**1.** Composition photopolymérisable cationiquement composée essentiellement de :

a1) au moins un polyphénol filmogène solide,
b1) au moins un phénol ayant des groupes latéraux époxypropyle et/ou un composé d'éther vinylique polyfonctionnel, qui présente une teneur en groupes hydroxyles, telle, qu'ils puissent être dissous, à l'état non durci dans une solution aqueuse alcaline en formant des sels,
c1) au moins un sel d'onium avec un anion faiblement nucléophile ou un sel de métallocène comme photoamorceur cationique pour le constituant b1), et
d1) éventuellement des adjuvants usuels.

**2.** Composition selon la revendication 1, dans laquelle le liant a1) est choisi dans le groupe comportant :

i) des novolaques à partir d'au moins un phénol et d'au moins un aldéhyde,
ii) des homo- et copolymères d'alcénylphénols et,
iii) des homo- et copolymères de N-hydroxyphénylmaléimides.

**3.** Composition selon la revendication 2, dans laquelle la novolaque i) dérive d'un phénol bicyclique ou monocyclique éventuellement substitué et d'un aldéhyde en $C_1$-$C_6$ ou des homo- ou copolymères des alcénylphénols ii), qui contient l'élément de structure de formule I :

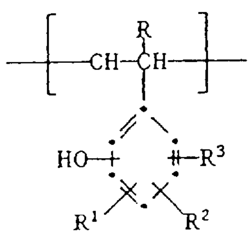

(I),

dans laquelle R représente l'hydrogène ou méthyle, $R^1$, $R^2$ et $R^3$, indépendamment les uns des autres, représentent l'hydrogène, alkyle en $C_1$-$C_4$, alcoxy en $C_1$-$C_4$, halogène et méthylol, ou les homo- ou copolymères du N-hydroxyphénylmaléimide iii) qui contient l'élément de structure de formule II :

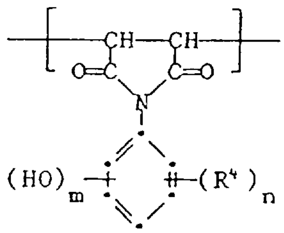

(II),

dans laquelle $R^4$ représente alkyle en $C_1$-$C_4$, alcoxy en $C_1$-$C_4$ ou halogène, m vaut 1 ou 2, n vaut 0, 1, 2, 3 ou 4, et la somme de m et de n est de 5 au maximum, les radicaux $R^4$ d'un cycle de phényle pouvant être différents dans le cadre des définitions données.

4. Composition selon la revendication 3, dans laquelle le liant ii) est un copolymère à base d'alcénylphénols et de composés vinyliques sans groupes carboxyle ou
le liant iii) est un copolymère à base de N-hydroxyphénylmaléimide et de composés vinyliques sans groupes hydroxyle.

5. Composition selon la revendication 1, dans laquelle le constituant bl) est un composé de formule XI :

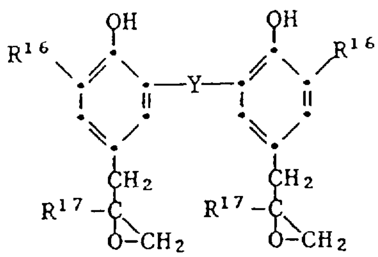

(XI),

dans laquelle $R^{16}$ représente alkyle en $C_1$-$C_6$, Y représente une liaison C-C directe ou un groupe $-CH_2-$,$-CH(CH_3)-$, $-C(CH_3)_2-$, -O-, -S-, -CO- ou $-SO_2-$ et $R^{17}$ représente l'hydrogène ou méthyle ; ou dans laquelle le constituant b1) est un o-alkylphénol novolaque modifié de formule XII :

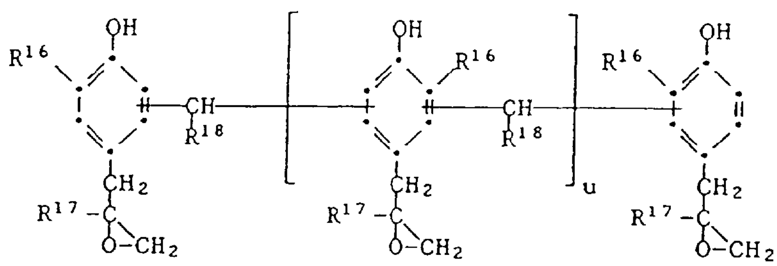

(XII),

dans laquelle $R^{16}$ et $R^{17}$ ont les définitions données ci-dessus, $R^{18}$ représente l'hydrogène ou alkyle en $C_1$-$C_6$ et u va de 1 à 6.

6. Composition selon la revendication 1, dans laquelle le constituant b1) est un phénol-novolaque modifié, constitué de motifs de structure de formules XIII et XIV :

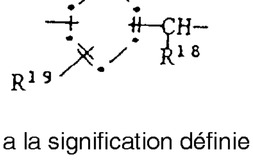

(XIII),

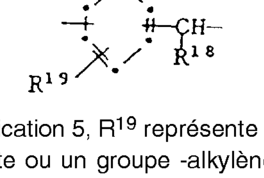

(XIV),

dans lesquelles $R^{18}$ a la signification définie dans la revendication 5, $R^{19}$ représente l'hydrogène, alkyle en $C_1$-$C_6$, le chlore ou le brome, D représente une liaison C-C directe ou un groupe -alkylène-O- avec 2 à 12 atomes de carbone, et la portion en motifs de structure de formule XIII étant tellement élevée que le composé non réticulé est soluble dans une solution aqueuse alcaline en formant des sels ; ou dans laquelle le constituant b1) est un polyhydroxystyrène modifié constitué de motifs de structure de formules XV et XVI ou aussi de motifs de structure de formules XV et XVII :

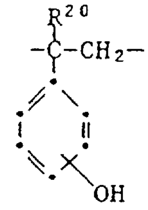 (XV), 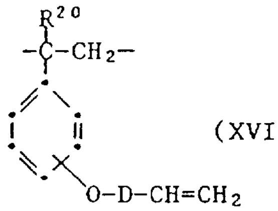 (XVI), 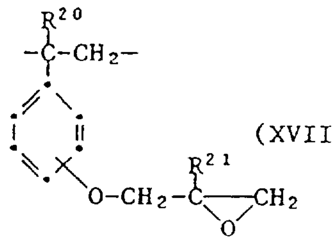 (XVII),

dans lesquelles $R^{20}$ et $R^{21}$, indépendamment l'un de l'autre, représentent l'hydrogène ou méthyle, D a la signification définie ci-dessus et la portion en motifs de structure de formule XV étant tellement élevée que le composé non réticulé est soluble dans une solution aqueuse alcaline en formant des sels.

**7.** Composition selon la revendication 1, dans laquelle le photoamorceur c1) est un composé de formule XVIII :

$$\left[ R^{29}(Fe^{II}R^{30})_s \right]_t^{+s} \left[ X \right]_s^{-t} \qquad (XVIII),$$

dans laquelle s vaut 1 ou 2, t vaut 1, 2, 3, 4 ou 5, X représente un anion non nucléophile, $R^{29}$ représente un $\pi$-arène et $R^{30}$ est un anion d'un $\pi$-arène.

**8.** Composé de formule XI :

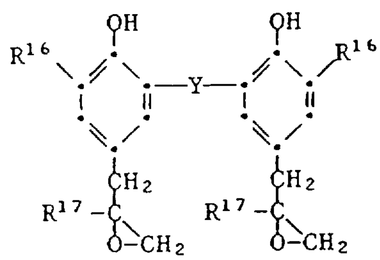 (XI),

dans laquelle Y, $R^{16}$ et $R^{17}$ ont les significations définies dans la revendication 5.

**9.** Procédé pour la préparation de structures en relief comprenant les étapes opérationnelles suivantes :

a) enduction d'un substrat d'une composition sensible aux rayonnement selon la revendication 1 ;
b) illumination du substrat enduit par un rayonnement actinique ayant un dessin prédéterminé, éventuellement
c) post-traitement thermique,
d) étape de développement, et éventuellement
e) post-traitement thermique du système développé.

**10.** Procédé pour la préparation de couches protectrices comprenant les étapes opérationnelles suivantes :

a) enduction d'un substrat d'une composition sensible aux rayonnements selon la revendication 1 ;
b) illumination de la couche sensible au rayonnement sur la totalité de sa surface ; et éventuellement
c) post-traitement thermique,

**11.** Utilisation de la composition selon la revendication 1, pour la préparation de couches protectrices et de structures en relief.